# EUROPEAN PATENT SPECIFICATION

(11) **EP 0 550 859 B1**
(45) Date of publication and mention of the grant of the patent: **27.03.1996**
(21) Application number: 92121506.7
(22) Date of filing: 17.12.1992
(51) Int. Cl.: C23C 16/44, C30B 25/14

(54) **Tube apparatus for manufacturing semiconductor device**
Rohreinrichtung zur Herstellung eines Halbleiterbauelementes
Dispositif de tube pour fabriquer un dispositif semi-conducteur

(30) Priority: 06.01.1992 KR 9254
(43) Date of publication of application: 14.07.1993
(73) Proprietor: SAMSUNG ELECTRONICS CO. LTD., Suwon, Kyungki-do (KR)
(72) Inventor: Yang, Chang-jip, Kwonsun-ku, Dyungki-do (KR); Ryu, Kyu-bok, Bucheon-city, Kyungki-do (KR); An, Jung-soo, Kyungki-do (KR); An, Jun-geen, Kyungki-do (KR)
(74) Representative: TER MEER - MÜLLER - STEINMEISTER & PARTNER

(56) References cited:
- DE-A- 2 220 807
- US-A- 4 803 948

## Description

The present invention relates to a tube apparatus for manufacturing a semiconductor device as claimed in the preamble of claim 1.

Such kind of tube apparatus is already known from US-A-4,803,948. This known tube apparatus for manufacturing a semiconductor device comprises a cylindrical tube having a door for loading a semiconductor wafer, whose one end is closed and having two openings being formed nearby, the other is conic and has an opening formed in the tip thereof.

In addition, from DE-A-22 20 807 a method and apparatus for depositing of polycrystalline thin films from silicon and silicon dioxide onto semiconductor substrates is known. Said apparatus comprises a reactor having heated walls. The reactor is composed of a reaction device and an end part. The end part is slidably inserted into the conical end of the reaction device. The end part comprises an inner tube inserted into the reaction device, whereas between the inner tube and the inner wall of the reaction device a ring chamber is provided. The back wall of the inner tube is closed and the inner tube is provided at the circumference thereof with a gas outlet tube. An outer wall of the end part having a closed back wall as well, and the circumference ofthe outer wall of the end part is provided with a gas inlet tube which is connected to the ring chamber mentioned above. The gas inlet tube is used for guiding a protection gas into the reaction chamber.

In manufacturing a semiconductor device, a tube made of quartz is employed in order to grow various layers or diffuse a dopant. A quartz tube is generally constituted by a process quartz tube (hereinafter referred to as process tube) having a silicon wafer for processing, and a dummy tube for venting the gas remaining after the processing.

A process tube is utilized in reacting the reactant gases entering via a gas inlet hole on the silicon wafer to grow a desired layer, or in diffusing doped impurities. Also, the dummy tube is mounted on the process tube and comprises a outlet hole for venting a non-reacted gas remaining in the process tube after reaction or by-products produced by the reaction. Into the dummy tube, nitrogen gas is introduced via a nitrogen curtain tube so that the pressure in the process tube is maintained constantly, and so that contaminants are prevented from being introduced into the process tube from the outside.

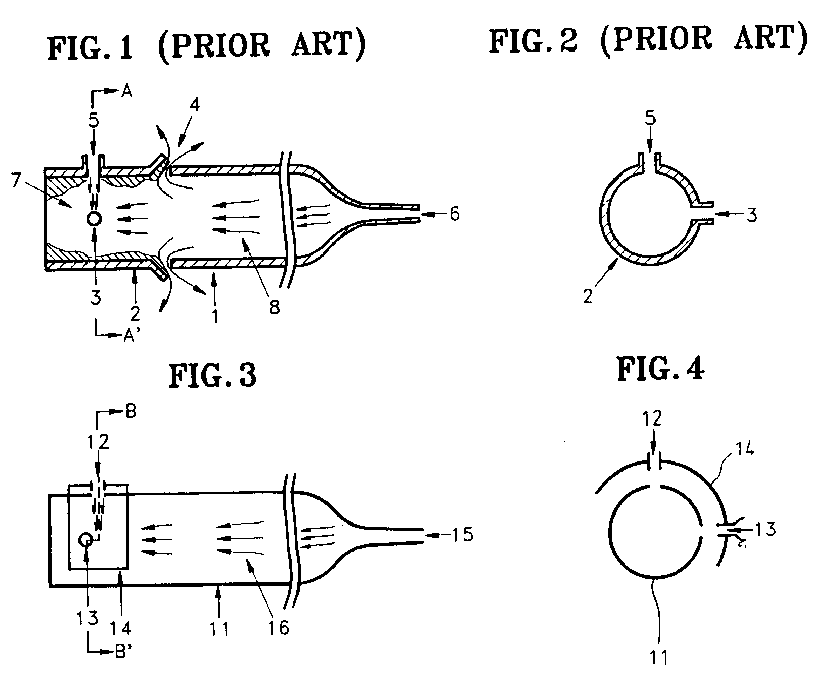

FIG.1 is a sectional view of a conventional tube apparatus during diffusion process, and FIG.2 is a cross-sectional view of the tube apparatus of FIG.1 taken along line A-A'.

In FIGs.1 and 2, reference number 1 denotes a process tube, 2 denotes a dummy tube, 3 denotes a gas outlet hole, 4 denotes a connecting portion of the process tube 1 and the dummy tube 2, 5 denotes a nitrogen curtain tube, 6 denotes a reactant gas inlet hole, 7 denotes a residue remaining in the dummy tube 2, and 8 denotes a reactant gas.

Firstly, a semiconductor wafer (not shown) is mounted on the process tube 1, and reactant gas 8 is introduced via gas inlet hole 6. At this time, nitrogen gas is introduced into the dummy tube 2 via nitrogen curtain tube 5 and forms a nitrogen curtain in the process tube 1. Reactant gas 8 introduced via gas inlet hole 6 grows a desired layer on the wafer or diffuse doped impurities. The nitrogen gas introduced via nitrogen curtain tube 5 maintains the pressure constantly in process tube 1 and prevents the reactant gas 8 from coming into contact with the outside, so that a contaminant is prevented from being introduced into the process tube 1.

After the process, non-reacted gas and reaction by-products are vented to the outside via the gas outlet hole 3 of the dummy tube 2.

In the conventional tube apparatus as above, the process tube 1 and the dummy tube 2 are connected to each other and have different temperature variations. That is, the temperature of dummy tube 2 is lower than that of process tube 1. Accordingly, the high temperature reactant gas and the reaction by-products from the process tube 1 condense to form residue 7 on the inner wall of the dummy tube 2. This residue 7 functions as a pollutant source when the wafer is loaded or unloaded into the process tube 1. Also, since the process tube 1 and the dummy tube 2 are connected to each other, a fine chink exists therebetween. Therefore, not only heat is emitted through this chink, but also reactant gas is leaked out of this chink to react with vapor in the ambient air so that a strong acidic material is formed and becomes solidified. As a result, the process tube 1 and the dummy tube 2 are firmly coupled, so that they cannot be separated. Therefore, re-using them is difficult. Additionally, since connection of the process tube 1 and the dummy tube 2 is very important, a great many cares should be taken for process maintenance and it takes a lot of time for handling the apparatus.

The object of the present invention is to provide a tube apparatus for manufacturing a semiconductor device by a very stable diffusion process and which further can be handled more easily.

In order to achieve the above object, according to the present invention, there is provided a saddle having two opening and mounted on the tube so that two openings thereof correspond to the two openings of the tube placed near the closed end.

In the tube apparatus of the present invention, a diffusion process is easy and the reactant gas residue does not remain in the process tube.

Further features and advantages will become more apparent from the following and more particular description of the preferred embodiment of the invention as illustrated in the accompanying drawings in which the same reference characters generally refer to like parts throughout the views, and in which:
FIG.1 is a sectional view of a conventional tube apparatus during diffusion process;
FIG.2 is a cross-sectional view of the tube apparatus of FIG.1 taken along line A-A';
FIG.3 is a schematic view of a tube apparatus mounted with saddle of the present invention during diffusion process;
FIG.4 is a schematic view of the closed end of the tube apparatus of FIG.3 taken along line B-B';
FIG.5 is a sectional view of a saddle mounted on the tube apparatus of the present invention;
FIG.6 is a right-side view of the saddle;
FIG.7 is a graph showing the processing ability index obtained using a conventional tube apparatus; and
FIG.8 is a graph showing the processing ability index obtained using a tube apparatus of the present invention.

FIG.3 is a schematic view of a tube apparatus mounted with saddle of the present invention during diffusion process and FIG.4 is a schematic view of the closed end of the tube apparatus of FIG.3 taken along line B-B'. In FIGs.3 and 4, a reference number 11 denotes a process tube, 12 denotes a nitrogen gas inlet hole, 13 denotes a gas outlet hole, 14 denotes a saddle, 15 denotes a reactant gas inlet hole, and 16 denotes a reactant gas.

The tube apparatus of the present invention is constituted by cylindrical process tube 11 having a door (not shown) for loading a semiconductor wafer. One end of the process tube 11 is closed and the other is constructed in the shape of a cone. An opening 15 is formed in the tip of the cone, and two openings 12 and 13 are formed near the closed end. Opening 15 formed at the cone is a reactant gas inlet hole, through which a reactant gas is introduced into the process tube 11. The process tube 11 of the present invention is made of a quartz having a good heat-resistance and chemical-resistance.

One of the two openings placed near the closed end of the process tube 11 is a nitrogen gas inlet hole 12, and the other is a gas outlet hole 13. Nitrogen gas is introduced into the process tube 11 via nitrogen gas inlet hole 12, so that the reactant gas is prevented from coming into contact with the ambient air and the pressure in the process tube is maintained constantly.

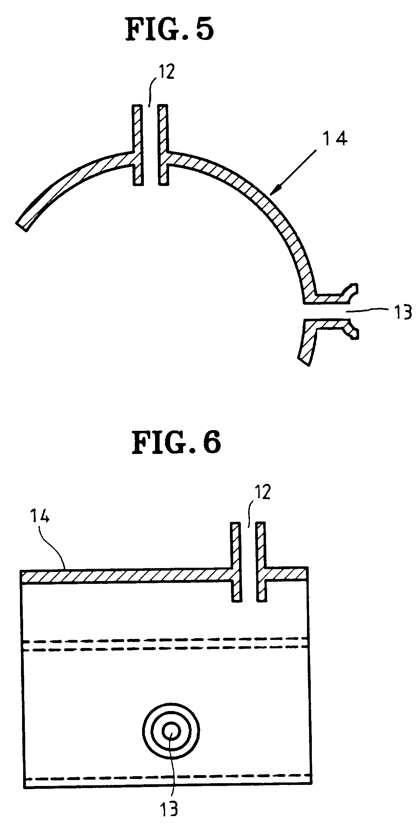

The process tube apparatus of the present invention is provided with a saddle 14. FIG.5 is a sectional view of saddle 14, and FIG.6 is a right-side view of the saddle. Saddle 14 has two openings which correspond to two openings 12 and 13 placed near the closed end of the process tube 11, and mounted on the process tube so as to correspond to the two process openings 12 and 13.

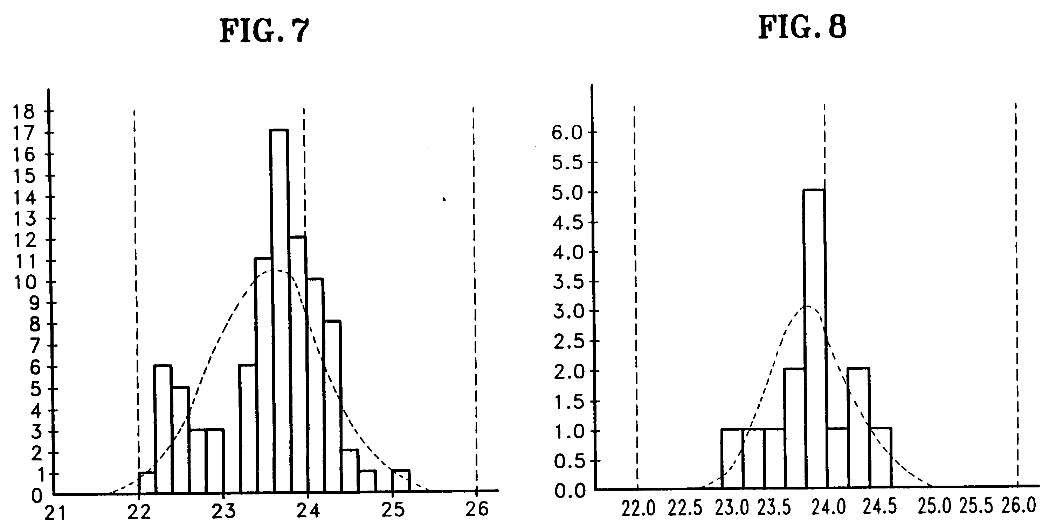

FIG.7 is a graph showing the processing ability index obtained when the diffusion process is carried out using a conventional tube apparatus, and FIG.8 is a graph showing the processing ability index obtained using a process tube apparatus of the present invention. In FlGs.7 and 8, the vertical axis shows the unit number in measuring the sheet resistance of the wafer, while the horizontal axis shows the sheet resistance of the wafer (Ω/□) measured after the diffusion process. Here, the predetermined sheet resistance value of the diffusion process was 24Ω/□.

The average sheet resistance of the wafer is 23.573Ω/□ when using the conventional tube apparatus, and 23.845Ω/□ when using the tube apparatus of the present invention. Also, the standard deviation is 0.65 when using the conventional tube apparatus, and 0.39 when using the tube apparatus of the present invention. Cₚ is obtained by means of the standard deviation, using the following equation.${\text{C}}_{\text{p}} \text{=} \frac{\text{standard deviation}}{\text{maximum value - average}}$

After determining the value of Cₚ, processing ability index Cₚₖ is determined by the following equation.${\text{C}}_{\text{pk}} {\text{= | 1-k | × C}}_{\text{p}}$ (wherein$\text{k =} \frac{\text{set value - average}}{\text{2}} \text{)}$

The processing ability index obtained by the above equation is 0.83 when using the conventional tube apparatus, and 1.59 when using the process tube apparatus of the present invention. The above result is shown in the following table I.

**Table 1**

| | conventional tube apparatus | tube apparatus of the present invention |
|---|---|---|
| standard deviation | 0.65 | 0.39 |
| Cₚₖ | 0.83 | 1.59 |

As evident from the above, the diffusion process is very stable when the process is carried out using a process tube apparatus of the present invention.

Also, since the saddle can be easily mounted on the process tube, it can be handled with ease. Furthermore, in a conventional tube apparatus, since a reactant gas residue remains on the connecting portion of a dummy tube and a process tube, the dummy tube and the process tube cannot be separated, so that the conventional tube apparatus cannot be used again. However, in the tube apparatus of the present invention, the saddle and process tube can be separated easily and no residue is formed in the process tube. Although the residue may form on the inner surface of the saddle, it can be easily removed. Therefore, the tube apparatus of the present invention is semi-permanent.

## Claims

1. A tube apparatus for manufacturing a semiconductor device comprising a cylindrical tube (11) having a door for loading a semiconductor wafer, whose one end is closed and having two openings (12, 13) being formed nearby, the other end is conic and having an opening (15) formed in the tip thereof; characterized by
a saddle (14) mounted on said tube (11) and having two openings so that said two openings of said saddle (14) correspond to said two openings (12, 13) of said tube (11) placed near said closed end.

2. The tube apparatus as claimed in claim 1, characterized in that said opening (15) formed in the tip of said conic end is a reactant gas inlet hole.

3. The tube apparatus as claimed in claim 1, characterized in that one of said two openings (12, 13) placed near said closed end is a nitrogen gas inlet hole (12), and the other is a gas outlet hole (13).

4. The tube apparatus as claimed in claim 1, characterized in that said tube (11) is composed of a quartz.

## Patentansprüche

1. Rohreinrichtung zur Herstellung eines Halbleiter-Bauelements, mit einem zylindrischen Rohr (11) mit einer Tür zum Einsetzen eines Halbleiterwafers, wobei das eine Ende des Rohrs geschlossen ist und zwei dicht beieinander ausgebildete Öffnungen (12, 13) aufweist und das andere Ende konisch ist und eine an seiner Spitze ausgebildete Öffnung (15) aufweist; **gekennzeichnet durch** einen Sattel (14), der am Rohr (11) angebracht ist und zwei Öffnungen in solcher Weise aufweist, daß diese zwei Öffnungen des Sattels (14) den zwei Öffnungen (12, 13) des Rohrs (11) entsprechen, die nahe dem geschlossenen Ende angebracht sind.

2. Rohreinrichtung nach Anspruch 1, **dadurch gekennzeichnet,** daß die in der Spitze des konischen Endes ausgebildete Öffnung (15) ein Reaktionsgas-Einlaßloch ist.

3. Rohreinrichtung nach Anspruch 1, **dadurch gekennzeichnet,** daß eine der zwei nahe dem geschlossenen Ende liegenden Öffnungen (12, 13) ein Stickstoffgas-Einlaßloch (12) ist und daß die andere ein Gasauslaßloch (13) ist.

4. Rohreinrichtung nach Anspruch 1, **dadurch gekennzeichnet,** daß das Rohr (11) aus Quarz besteht.

## Revendications

1. Un appareil tubulaire pour la fabrication d'un dispositif semiconducteur, comprenant un tube cylindrique (11) qui est muni d'une porte pour charger une pastille de semiconducteur, dont l'une des extrémités est fermée et qui comporte deux ouvertures (12, 13) formées à proximité, l'autre extrémité étant conique et présentant une ouverture (15) disposée à son sommet;
caractérisé par:
- une selle (14) montée sur ledit tube (11) et présentant deux ouvertures disposées de telle façon que lesdites deux ouvertures de ladite selle (14) correspondant auxdites deux ouvertures (12, 13) dudit tube (11) placées à proximité de ladite extrémité fermée.

2. L'appareil tubulaire selon la revendication 1, caractérisé en ce que ladite ouverture (15) disposé au sommet de ladite extrémité conique est une ouverture d'entrée d'un gaz réactif.

3. L'appareil tubulaire selon la revendication 1, caractérisé en ce que l'une desdites deux ouvertures (12, 13) disposées au voisinage de ladite extrémité fermée est une ouverture d'entrée d'azote gazeux (12), et l'autre ouverture (13) est une ouverture de sortie de gaz.

4. L'appareil tubulaire selon la revendication 1, caractérisé en ce que ledit tube (11) est constitué de quartz.
